# FASCICULE DE BREVET EUROPEEN

(11) **EP 1 290 721 B1**
(45) Date de publication et mention de la délivrance du brevet: **21.01.2015**
(21) Numéro de dépôt: 01943590.8
(22) Date de dépôt: 08.06.2001
(51) Int. Cl.: H01L 21/02, C30B 23/02, C30B 29/40, C30B 25/02

(54) **PROCEDE DE PREPARATION D'UNE COUCHE DE NITRURE DE GALLIUM**
VERFAHREN ZUR HERSTELLUNG EINER GALLIUMNITRID-SCHICHT
METHOD OF FORMING A GALLIUM NITRIDE LAYER

(30) Priorité: 09.06.2000 FR 0007417
(43) Date de publication de la demande: 12.03.2003
(73) Titulaire: CENTRE NATIONAL DE LA RECHERCHE SCIENTIFIQUE -CNRS-, 75794 Paris Cedex 16 (FR)
(72) Inventeur: SEMOND, Fabrice, F-06250 Mougins le Haut (FR); MASSIES, Jean, Claude, F-06560 Valbonne (FR); GRANDJEAN, Nicolas, Pierre, F-06000 Nice (FR)
(74) Mandataire: Regimbeau
(86) Numéro de dépôt international: PCT/FR2001/001777
(87) Numéro de publication internationale: WO 2001/095380

(56) Documents cités:
- EP-A- 0 551 721
- WO-A-00/16378
- WO-A-00/25353
- WO-A-99/25030
- US-A- 4 855 249
- PATENT ABSTRACTS OF JAPAN vol. 1997, no. 11, 28 novembre 1997 (1997-11-28) & JP 09 199759 A (TOYODA GOSEI CO LTD;AKASAKI ISAMU; AMANO HIROSHI), 31 juillet 1997 (1997-07-31)
- PATENT ABSTRACTS OF JAPAN vol. 1998, no. 04, 31 mars 1998 (1998-03-31) & JP 09 312546 A (KYOCERA CORP), 2 décembre 1997 (1997-12-02)
- NIKISHIN S A ET AL: "HIGH QUALITY GAN GROWN ON SI(111) BY GAS SOURCE MOLECULAR BEAM EPITAXY WITH AMMONIA" APPLIED PHYSICS LETTERS,AMERICAN INSTITUTE OF PHYSICS. NEW YORK,US, vol. 75, no. 14, 4 octobre 1999 (1999-10-04), pages 2073-2075, XP000875612 ISSN: 0003-6951 cité dans la demande

## Description

L'invention concerne les couches, en particulier les couches épaisses, monocristallines de nitrure de gallium ou de nitrure mixte de gallium et d'un autre métal, ainsi que leur procédé de préparation.

L'invention a trait, en outre, aux dispositifs électroniques ou optoélectroniques comprenant de telles couches.

Le domaine technique de l'invention peut être défini de manière générale comme celui de la préparation de couches de matériaux semi-conducteurs à base de nitrures sur un substrat.

Les matériaux semi-conducteurs à base de nitrures des éléments des groupes III à V du tableau périodique occupent et occuperont une place de plus en plus importante dans les domaines de l'électronique et de l'optoélectronique. Le domaine d'application de ces matériaux semi-conducteurs à base de nitrures couvre, en effet, un large spectre qui s'étend des diodes lasers jusqu'aux transistors capables de fonctionner à haute fréquence et haute température, en passant par les photodétecteurs ultraviolets, les dispositifs à ondes acoustiques de surface et les diodes électroluminescentes (DEL).

Dans ces composants, le substrat le plus couramment utilisé pour la croissance des nitrures est le saphir et, dans une moindre mesure, le carbure de silicium SiC. Ces deux matériaux et notamment le saphir présentent un certain nombre d'inconvénients.

Les inconvénients du saphir sont qu'il est un isolant électrique et un mauvais conducteur thermique, tandis que les inconvénients du SiC sont qu'il est cher et de qualité variable. Il a donc été envisagé de les remplacer par le silicium qui possède des avantages évidents, aussi bien d'un point de vue économique que technique par rapport aux deux matériaux précités.

En effet, entre autres propriétés intéressantes, le silicium est un bon conducteur thermique, et il peut être facilement éliminé par voie chimique.

Par ailleurs, du fait qu'il existe d'ores et déjà une filière technologique sur silicium parfaitement maîtrisée à l'échelle industrielle, et que son coût est très nettement inférieur à ceux du saphir et du SiC, le silicium est le substrat de choix pour une production de masse à bas coût.

La croissance de nitrures, tels que le nitrure de gallium, sur des substrats en silicium se heurte aux problèmes dus aux différences importantes existant entre les paramètres de maille et le coefficient de dilatation thermique du substrat et du nitrure. Pour faire croître une couche de nitrure, tel que le GaN, de bonne qualité, il est donc communément admis qu'il faut, au préalable, déposer sur le substrat de silicium une fine couche, par exemple, d'AlAs, de SiC ou d'AlN, dite « couche tampon », d'une épaisseur de quelques dizaines de nanomètres. Cette couche recouvre continûment le substrat et permet à la couche de GaN de croître de façon bidimensionnelle. Cependant, du fait du désaccord, mentionné plus haut, du paramètre de maille et du coefficient de dilatation thermique entre le silicium et le GaN, les couches de GaN sur substrat silicium se trouvent en extension. La valeur de cette contrainte extensive, générée lors du refroidissement suivant la croissance, augmente avec l'épaisseur de la couche de nitrure, tel que le GaN, et il se forme des craquelures dans cette couche, au-delà d'une épaisseur critique, généralement supérieure à 1 *µ*m.

Par conséquent, les couches de nitrures, telles que les couches de GaN épitaxiées sur un substrat en silicium, sont soit fines et sans craquelures, soit épaisses, mais craquées.

Dans les deux cas, ces couches sont difficilement utilisables.

Le même problème se rencontre dans le cas de la croissance de couches de nitrures, tels que le GaN, sur les substrats en carbure de silicium SiC.

Il est évident qu'en augmentant l'épaisseur de la couche de GaN, on améliore aussi bien les propriétés structurales, optiques, qu'électriques. De ce fait, la préparation de couches de nitrures, notamment de GaN, épaisses, sans craquelures, sur un substrat en silicium, est d'un intérêt fondamental.

Afin d'éliminer les craquelures et de limiter la contrainte extensive des couches de GaN sur silicium, le document de S. A. NIKISHIN, N. N. FALEEV, V. G. ANTIPOV, S. FRANCOEUR, L. GRAVE DE PERALTA, G. A. SERYOGIN, H. TEMKIN, T. I. PROKOFYEVA, M. HOLTZ et S. N. G. CHU, APPL. PHYS. LETT. 75, 2 073 (1999) indique que le mode de croissance de la fine couche tampon d'AlN, déposée sur le substrat de silicium, doit transiter le plus rapidement possible vers un mode de croissance bidimensionnel. Des couches de GaN sans craquelures, d'une épaisseur pouvant aller jusqu'à 2,2 *µ*m, sont ainsi obtenues.

Il s'avère que cette augmentation de l'épaisseur critique d'apparition des craquelures est due à un prétraitement de la surface du substrat de silicium qui consiste à exposer la surface de silicium désoxydée pendant quelques secondes à l'ammoniac avant de déposer une monocouche d'aluminium et de commencer la croissance de la couche tampon d'AlN.

En outre, avec ce prétraitement, la croissance de la couche tampon d'AlN transite plus rapidement vers un mode de croissance bidimensionnel.

Cependant, les couches ainsi préparées présentent encore une légère contrainte résiduelle extensive, et au-delà d'environ 2 *µ*m, les couches craquent.

Il existe donc un besoin pour des couches monocristallines, en particulier épaisses, et continues, c'est-à-dire sans craquelures, de nitrure de gallium et de ses alliages, sur un substrat susceptible d'occasionner des contraintes extrensives dans les couches.

Il existe, en outre, un besoin pour un procédé de préparation de telles couches sur un tel substrat, qui soit, entre autres, fiable, simple, reproductible, et peu coûteux. Il est par ailleurs connu d'intercaler, dans une couche de nitrure de gallium ou de nitrure mixte de gallium et d'un autre métal, une ou plusieurs couches intercalaires d'un matériau déposé sous forme amorphe puis cristallisé au moyen d'une élévation de température. Ainsi, le document WO 99/25030 prévoit l'insertion, dans une couche de nitrure de gallium, d'au moins une couche intercalaire déposée sous forme amorphe puis cristallisée, dont l'épaisseur peut être comprise entre 0,2 et 800 nm, et qui joue le rôle d'arrêt des dislocations présentes dans la couche de nitrure sous-jacente. Elle permet ainsi de réduire la densité de dislocations dans la couche de nitrure sus-jacente. Toutefois, le nombre de couches intercalaires que l'on peut ainsi insérer est limité sous peine de provoquer des craquelures dans la couche de nitrure. Le document WO 00/25353 adresse ce problème en proposant d'insérer dans la couche de nitrure une coucheintercalaire apte à imposer à la couche de nitrure sus-jacente des contraintes compressives permettant de compenser les contraintes extensives générées dans la couche sus-jacente. La couche intercalaire insérée à cet effet est une couche de 10 à 100 nm d'épaisseur, déposée sous forme amorphe puis partiellement cristallisée, de sorte qu'elle comprenne des régions amorphes et polycristallines.

Le but de la présente invention est de répondre, entre autres, à l'ensemble des besoins mentionnés ci-dessus et de fournir une couche et un procédé de préparation qui ne présentent pas les inconvénients, défauts, limitations et désavantages des couches et procédé de l'art antérieur.

Plus prégisement, le but de la présente invention est de fournir des couches monocristallines de nitrate de gallium et de ses alliages, qui soient exemples de craquelures.

Ce tout, et d'autres encore, sont atteints, conformément à l'invention par une couche monocristalline sans craquelure, de nitrure de gallium ou de nitrure mixte de gallium et d'un autre métal, sur un substrat susceptible d'occasionner des contraintes extensives dans la couche, ledit substrat étant recouvert d'une couche tampon ; dans laquelle au moins une couche monocristalline d'un matériau dont l'épaisseur est de 100 à 300 nm, de préférence de 200 à 250 nm, et dont le paramètre de maille est inférieur au paramètre de maille du nitrure de gallium un nitrure mixte de gallium et d'un autre métal, est intercalée dans la couche de nitrure de gallium ou de nitrure mixte de gallium et d'un autre métal.

Selon l'invention, le paramètre de maille du matériau de la couche monocristalline intercalaire est inférieur au paramètre de maille du nitrure de gallium ou du nitrure mixte de gallium et d'un autre métal.

En effet, pour le but recherché, quelle que soit la couche intercalaire et quelle que soit la couche monocristalline de nitrure, le paramètre de maille de la couche monocristalline intercalaire doit être inférieur à celui de la couche de nitrure.

La couche selon l'invention peut avoir une épaisseur quelconque, par exemple elle peut avoir une épaisseur de 1 *µ*m, voire moins. La couche selon l'invention peut notamment être une couche épaisse ; par couche épaisse, selon l'invention, on entend généralement une couche d'une épaisseur supérieure ou égale à 2 *µ*m, par exemple de 2 à 5 *µ*m, de préférence de plus de 2 à 5 *µ*m, de préférence encore de 3 à 5 *µ*m.

Les couches de l'invention se différencient fondamentalement des couches de l'art antérieur en ce sens qu'elles présentent au moins une couche monocristalline intercalaire présentant un paramètre de maille inférieur au paramètre de maille du nitrure de gallium ou du nitrure mixte de gallium et d'un autre métal, en ce que précisément cette couche est spécifiquement, fondamentalement une couche monocristalline et non pas une couche polycristalline ou encore une couche amorphe, et enfin en ce que,la couche intercalaire a une épaisseur spécifique de 100 à 300 nm. En effet, selon l'invention, on vise à jouer sur la contrainte, donc on utilise des couches intercalaires « épaisses », alors que dans l'art antérieur où on vise à jouer sur les défauts, on utilise des couches fines de quelques dizaines de nanomètres.

Il est essentiel et fondamental, selon l'invention, que la couche selon l'invention comporte non seulement une couche intermédiaire intercalaire, présentant un paramètre de maille inférieur à celui du GaN, mais encore, en outre, que cette couche intercalaire intermédiaire soit une couche spécifique monocristalline et enfin que cette couche ait une épaisseur spécifique.

Cette couche est généralement réalisée dans des conditions précises et définies, notamment à une haute température, à savoir généralement à une température de 800 à 1 000°C, de préférence de 900 à 950°C.

Seule, une couche intercalaire spécifiquement monocristalline, avantageusement réalisée à haute température, selon l'invention, permet notamment de résoudre avec succès le problème technique spécifique de la formation des craquelures.

Il n'est jamais mentionné, ni suggéré dans l'art antérieur qu'une couche intercalaire monocristalline (par exemple d'AlN), avantageusement réalisée à haute température, puisse permettre d'obtenir des couches de GaN épaisses, non craquelées.

Le désaccord de paramètre de maille (à savoir, paramètre de maille du matériau de la couche intercalaire inférieur au paramètre de maille du nitrure de gallium ou du nitrure mixte de gallium et d'un autre métal) est tel que la ou les couche(s) de nitrures supérieure(s) se trouvent en compression pendant la croissance.

Cette compression compense, voire annule, la contrainte extensive qui se produit lors du refroidissement, et les couches de nitrure de gallium ou de nitrure mixte de gallium et d'un autre métal peuvent, à la fois, et de manière totalement surprenante être, par exemple épaisses et sans craquelures, en d'autres termes, continues, sur un substrat susceptible d'occasionner des contraintes extensives dans la couche.

A la différence des couches du document de NIKISHIN et al., les couches, selon l'invention, comprennent, outre la couche tampon, une autre couche intercalaire, au sein même du matériau de gallium ou de nitrure mixte de gallium et d'un autre métal, qui permet d'éliminer effectivement les craquelures que la couche tampon, seule, ne permet pas d'éviter.

En d'autres termes, la couche intercalaire selon l'invention permet notamment d'augmenter sensiblement l'épaisseur critique d'apparition des craquelures par rapport à l'utilisation de la seule couche tampon.

Cela signifie que la couche intercalaire permet d'imposer une plus forte contrainte compressive qui vient compenser exactement, ou en partie, la contrainte extensive qui s'établit lors du refroidissement. De ce fait, les couches, selon l'invention, ont une épaisseur exempte de craquelures, qui n'a jamais pu être atteinte dans l'art antérieur, puisque, dans le document cité plus haut, l'épaisseur maximum des couches sans craquelures est de seulement 2 *µ*m, alors qu'elle peut atteindre 3 *µ*m, voire plus, c'est-à-dire jusqu'à 5 *µ*m, selon l'invention.

Il est toutefois à noter que l'invention ne se limite pas aux couches « épaisses », mais est relative à toutes les couches présentant la structure selon l'invention, par exemple les couches pourront avoir une épaisseur de 1 *µ*m ou moins.

En outre, fondamentalement, la couche intercalaire est une couche monocristalline et non amorphe ou polycristalline.

Avantageusement, les nitrures mixtes de gallium sont choisis parmi les nitrures mixtes de gallium avec l'aluminium ou l'indium.

Le substrat peut être tout substrat utilisé dans ce domaine de la technique, et qui serait susceptible d'occasionner des contraintes extensives dans la couche, mais il s'agit, de préférence, d'un substrat choisi parmi les substrats en silicium et en carbure de silicium.

Précisément, grâce à l'invention, on dispose maintenant de couches, en particulier de couches épaisses, sans craquelures sur de tels substrats. Ces substrats présentent, par ailleurs, de nombreux avantages, mais les inconvénients liés aux contraintes générées étaient tels que l'utilisation de tels substrats, malgré ces avantages, était proscrite dans l'art antérieur.

Les substrats en carbure de silicium s'avèrent être particulièrement adaptés aux types de composants que l'on souhaite réaliser avec les nitrures.

Le substrat en silicium est, de préférence, un substrat en silicium orienté suivant le plan (111), de préférence également le silicium est désoxydé.

La couche tampon est, de préférence, une couche d'AlN, de préférence, en outre, cette couche est une couche fine d'une épaisseur généralement de 10 à 50 nm.

La couche intercalaire peut être en un matériau identique ou différent de celui de la couche tampon. Cependant, la couche intercalaire est généralement une couche d'AlN ou d'AlGaN. Cette couche est, selon l'invention, une couche monocristalline.

L'épaisseur de ladite couche intercalaire est de 100 à 300 nm, de préférence de 200 à 250 nm.

La couche selon l'invention peut comporter de 1 à 5 couches intercalaires.

L'invention concerne aussi un procédé pour la préparation d'une couche monocristalline, sans craquelures, de nitrure de gallium ou de nitrure mixte de gallium et d'un autre métal sur un substrat susceptible d'occasionner des contraintes extensives dans la couche, ledit procédé comprenant les étapes successives suivantes :
a) exposition éventuelle de la surface du substrat chauffé à de l'ammoniac ; ce traitement est effectué dans le cas où le substrat est en silicium ;
b) dépôt d'une monocouche atomique d'aluminium ;
c) dépôt d'une couche tampon ;
d) croissance d'un dépôt de nitrure de gallium ou de nitrure mixte de gallium et d'un autre métal ;
e) interruption de la croissance du dépôt de nitrure de gallium ou de nitrure mixte de gallium et d'un autre métal ;
f) croissance d'une couche monocristalline intercalaire d'un matériau dont le paramètre de maille est inférieur au paramètre de maille du nitrure de gallium ou du nitrure mixte de gallium et d'un autre métal, et dont l'épaisseur est de 100 à 300 nm, de préférence de 200 à 250 nm ;
g) répétition éventuelle des étapes d) à f) ;
h) poursuite de la croissance du dépôt de nitrure de gallium ou de nitrure mixte de gallium et d'un autre métal jusqu'à l'épaisseur finale souhaitée de la couche de nitrure de gallium ou de nitrure mixte de gallium et d'un autre métal.
i) refroidissement du substrat et de la couche de nitrure de gallium ou de nitrure mixte de gallium et d'un autre métal.

L'étape fondamentale du procédé selon l'invention, qui le différencie de manière essentielle des procédés de l'art antérieur, est l'étape f).

Comme on l'a déjà indiqué plus haut, le fait d'intercaler au moins une couche monocristalline d'un matériau présentant un désaccord de paramètre de maille (voir plus haut) avec le nitrure de gallium, c'est-à-dire un paramètre de maille plus petit que le nitrure de gallium ou que le nitrure mixte de gallium dans la couche de GaN ou de nitrure mixte de gallium et d'un autre métal compense, voire annule, la contrainte extensive apparaissant lors du refroidissement, par exemple, jusqu'à température ambiante, de ce fait, grâce au procédé de l'invention, on peut préparer des couches, notamment des couches épaisses, sans craquelures, continues, sur un substrat susceptible d'occasionner, d'induire, des contraintes extensives dans la couche.

En effet, le procédé de l'invention, du fait de l'étape f) de croissance d'une couche intercalaire qui est spécifiquement, fondamentalement, monocristalline, permet notamment d'imposer une plus forte contrainte compressive que celle créée dans le procédé de l'art antérieur, décrit dans le document de NIKISHIN et al.

Cette contrainte compressive vient compenser exactement ou en partie la contrainte extensive qui s'établit lors du refroidissement avec, pour conséquence, l'obtention de couches qui peuvent être relaxées et dont l'épaisseur critique d'apparition des craquelures est accrue de manière significative, comme on l'a indiqué plus haut.

En effet, les couches obtenues, suivant leur épaisseur, ont un état de contrainte différent. Les couches fines, inférieures à 1 *µ*m, sont relaxées alors que les couches, supérieures à 1 *µ*m, sont de nouveau en extension, mais elles ne craquent qu'au-delà de 3 *µ*m.

Il n'était absolument pas prévisible qu'en ajoutant cette étape supplémentaire f) de croissance d'une couche intercalaire aux étapes connues a), b), c), d) du procédé de l'art antérieur, cette couche étant, en outre, fondamentalement monocristalline et comprenant une épaisseur spécifique, on pourrait ainsi surmonter les inconvénients de l'art antérieur.

En effet, en réalisant notamment, en plus du prétraitement de surface a) de l'art antérieur, la croissance d'une couche intercalaire, des couches, en particulier des couches de grande épaisseur relaxées, ou contraintes, mais non craquées, peuvent être préparées, conformément à l'invention.

Il est, en outre, essentiel, selon l'invention, que la couche intercalaire que l'on fait croître soit une couche monocristalline qui, seule, permet d'obtenir des couches finales, notamment épaisses et sans craquelure.

Il est aussi important que la couche intercalaire ait une épaisseur spécifique de 100 à 300 nm, qui permet de jouer sur la contrainte.

En d'autres termes, bien que les étapes a), b), c) et d) du procédé de l'invention soient similaires au procédé de l'art antérieur, mentionné plus haut, la comparaison des valeurs de la contrainte résiduelle et de l'épaisseur maximum réalisable sans craquelure, qui est généralement de 3 *µ*m ou plus, dans le cas du présent procédé, contre 2 *µ*m dans l'art antérieur, démontre que l'étape supplémentaire du procédé de l'invention joue un rôle essentiel, décisif, pour augmenter la contrainte compressive et compenser davantage l'extension qui se produit lors du refroidissement.

Les conditions de croissance de la couche intercalaire selon l'invention sont importantes et doivent être choisies, précisément, de telle sorte que cette couche soit monocristalline.

En particulier, la température utilisée lors de la croissance de la couche intercalaire est avantageusement une température élevée, généralement de 800 à 1 000°C, de préférence de 900 à 950°C.

Les autres paramètres ou conditions de croissance qui doivent généralement être choisis de manière précise sont notamment la vitesse de croissance et l'épaisseur de couche intercalaire à faire croître.

En outre, le procédé selon l'invention est simple, fiable et reproductible, ainsi, à titre d'exemple, il a été montré que la reproductibilité du procédé était de 100 % pour une vingtaine de couches réalisées.

Le substrat, comme mentionné plus haut, peut être tout substrat susceptible d'occasionner des contraintes extensives dans la couche. C'est là un des avantages du procédé de l'invention que de ne pas dépendre a priori du substrat et d'être d'une application très générale. En effet, l'étape essentielle où il s'agit d'intercaler une couche monocristalline, par exemple, d'AlN dans la couche de nitrure de gallium ou de nitrure mixte de gallium et d'un autre métal, est totalement indépendante du substrat. Les substrats préférés ont été indiqués plus haut.

En outre, le procédé selon l'invention peut indifféremment utiliser n'importe quelle technique de croissance pour le dépôt de la couche tampon, la croissance des dépôts de nitrure de gallium ou de nitrure mixte de gallium et d'un autre métal, et pour la croissance de la couche intercalaire. Toutefois, les conditions de croissance de celle-ci doivent être telles qu'elle soit monocristalline.

On pourra donc utiliser l'épitaxie par jets moléculaires (EJM) (« MBE » ou Molecular Beam Epitaxy, en anglais) déjà mentionné ci-dessus, le dépôt chimique en phase vapeur d'organométalliques (« MOCVD » ou Metalorganic Chemical Vapour Deposition, en anglais), l'épitaxie en phase vapeur par la méthode aux hydrures (« HVPE » ou Hydride Vapour Phase Epitaxy, en anglais), pour la croissance de ces couches et dépôts. Le procédé préféré est l'EJM, généralement dans les conditions suivantes, qui permettent d'assurer la croissance d'une couche intercalaire monocristalline : température de 800 à 1 000°C, de préférence de 900 à 950°C, et vitesse de croissance de 0,1 à 0,5 *µ*m/h.

De plus, il est possible, grâce au procédé de l'invention, de déposer plusieurs couches intercalaires, par exemple, d'AlN dans la couche de nitrure de gallium ou de nitrure mixte de gallium et d'un autre métal, c'est-à-dire que, comme on l'a mentionné en g), les étapes d) à f) peuvent être répétées, par exemple, de 1 à 5 fois, conduisant alors au dépôt de 2 à 6 couches monocristallines intercalaires.

Le procédé selon l'invention est donc d'une grande flexibilité, aussi bien du point de vue du choix du substrat, que du procédé de croissance des dépôts et couches.

Cela n'est pas le cas du procédé de l'art antérieur, tel que décrit dans le document de NIKISHIN et al., car il est bien évident que dans ce procédé la rapidité de la transition de croissance tridimensionnelle/bidimensionnelle de la couche AlN sera dépendante du substrat et de la technique de croissance utilisés.

En outre, ce procédé ne peut s'appliquer qu'une seule fois à l'interface entre le substrat et la couche tampon d'AlN. Le procédé selon l'invention a donc l'avantage de pouvoir s'appliquer, se transposer tel quel, lors de l'utilisation, par exemple, de substrats de carbure de silicium au lieu de substrats de silicium, ces substrats de SiC, on l'a vu, s'avèrent être particulièrement bien adaptés aux types de composants que l'on souhaite réaliser avec les nitrures.

L'invention concerne, en outre, un dispositif électronique et/ou optoélectronique comprenant au moins une couche monocristalline, épaisse, sans craquelures de nitrure de gallium ou de nitrure mixte de gallium et d'un autre métal, selon l'invention, telle que décrite ci-dessus.

De tels dispositifs sont, par exemple, les diodes lasers, les transistors capables de fonctionner à haute fréquence et haute température, les photodétecteurs ultraviolets, les dispositifs à ondes acoustiques de surface, les diodes électroluminescentes, etc..

L'inclusion, dans ces dispositifs électroniques, des couches, selon l'invention, améliore grandement les performances, il est, en effet, évident qu'en augmentant l'épaisseur de la couche de nitrure de gallium ou de nitrure mixte de gallium et d'un autre métal, on améliore, à la fois, les propriétés structurales, optiques et électriques. A titre d'exemple, le seul document à ce jour A. T. SCHREMER, J. A. SMART, Y. WANG, O. AMBACHER, N. C. MacDONALD et J. R. SHEALY, Appl. Phys. Lett. 76, 736 (2000), qui fait état de la réalisation de transistors à base d'hétérostructures nitrures sur substrat silicium mentionne des valeurs de mobilité comprises entre 600 et 700 cm²/Vs, alors qu'en utilisant les couches de l'invention, on obtient des valeurs supérieures à 1 500 cm²/Vs à 300 K. Ceci est essentiellement dû au fait que, dans ce document, on ne peut réaliser de couches supérieures à 0,7 *µ*m, sans éviter la formation de craquelures. Ainsi, les hétérostructures de ce document sont de moins bonne qualité que celles réalisées selon l'invention sur des couches d'au moins 2 *µ*m.

Cet exemple sur l'amélioration des performances concerne les transistors, mais en réalité, quelle que soit l'application, les dispositifs qui seront réalisés à partir des couches épaisses, selon l'invention, auront de meilleures caractéristiques que ceux réalisés sur des couches fines, tout simplement parce que plus l'on s'éloigne de l'interface avec le substrat, plus le matériau épitaxié est de bonne qualité.

L'invention va maintenant être décrite de manière plus précise, dans la description détaillée qui va suivre, donnée à titre illustratif et non limitatif, faite en référence aux dessins joints, dans lesquels :
- la figure 1 est un graphique qui schématise pour des dépôts et croissances par MBE, les différentes étapes du procédé de l'invention, en donnant la température T (°C), en fonction du temps t (minutes), au cours de ces étapes ;
- la figure 2 présente en coupe schématique une couche de GaN selon l'invention ;
- les figures 3A et 3B sont des photographies au microscope optique d'une couche de GaN de 2 *µ*m d'épaisseur ne comprenant pas de couche intercalaire (non conforme à l'invention), et d'une couche de GaN de 2 *µ*m d'épaisseur comprenant une couche intercalaire (conforme à l'invention) ;
- les figures 4B et 4A sont respectivement des spectres de photoluminescence et de réflectivité obtenus avec du GaN d'épaisseur 1 *µ*m sans couche intercalaire (non conforme à l'invention) et une couche de GaN de même épaisseur comprenant une couche intercalaire (conforme à l'invention). En ordonnées sont portées des unités arbitraires (u.a) et en abscisses est portée l'énergie des photons E (eV).

Le procédé selon l'invention et les couches de l'invention, sont décrits dans ce qui suit.

Les substrats utilisés sont de préférence des « wafers » (ou galettes) de silicium orientés suivant le plan (111).

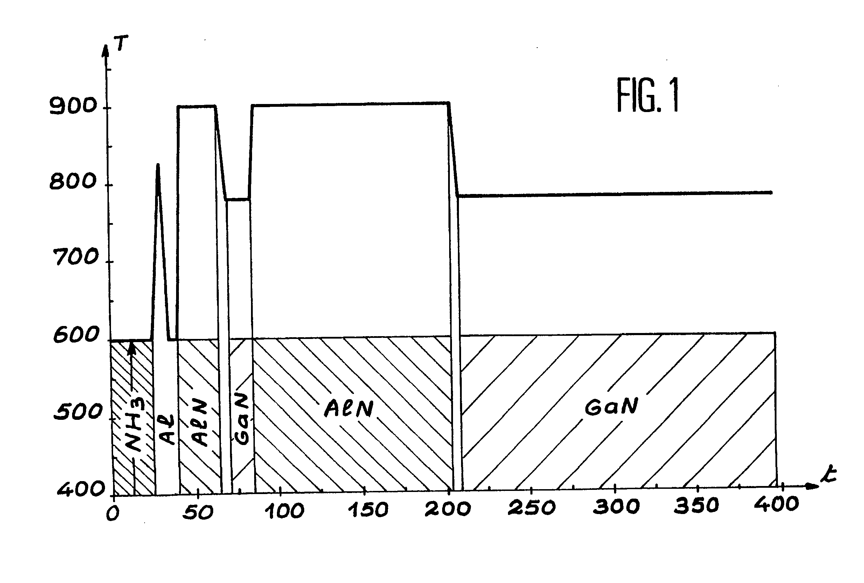

Avant de commencer la croissance, de la couche proprement dite, la couche d'oxyde natif qui recouvre le substrat de silicium est évaporée in situ dans la chambre de croissance par des recuits thermiques rapides, par exemple, jusqu'à 950°C : il s'agit là de l'étape dite de « désoxydation » (étape 0), cette étape n'est pas représentée sur la figure 1.

On débute ensuite le procédé selon l'invention (à l'instant 0, sur la figure 1). La température du substrat est fixée généralement à, par exemple, 600°C et la surface du silicium est exposée pendant quelques secondes (à savoir généralement de 2 à 10 secondes à de l'ammoniac (étape 1).

La température du substrat est ensuite augmentée généralement jusqu'à environ 830°C. Après avoir ramené la température du substrat généralement à 600°C une monocouche atomique d'aluminium est déposée (étape 2).

On initie alors la croissance de la couche tampon généralement d'AlN en augmentant la température à 900°C (étape 3).

Notons que le procédé, décrit ici, est le procédé EJM ou « MBE » (Epitaxie par Jets Moléculaires).

Après un dépôt de 10 à 50 nanomètres, par exemple d'une durée de 30 minutes de couche tampon, la croissance est arrêtée et la température est descendue généralement jusqu'à 780°C. La croissance de GaN ou de nitrure mixte de gallium et d'un autre métal est réalisée à cette température sur la couche tampon, par exemple, d'AlN (étape 4).

La croissance de GaN ou de nitrure mixte de gallium et d'un autre métal est interrompue après dépôt d'une épaisseur de 100 à 300 nm (par exemple 250 nm sur la figure 1) et la température est portée généralement à 900°C pour effectuer la croissance d'une couche intercalaire monocristalline d'AlN, dans le cas où la couche tampon et la couche intercalaire sont toutes deux constituées d'AlN. Cette couche intercalaire monocristalline a une épaisseur de 100 à 300 nm.

Après la croissance de cette couche intercalaire monocristalline, on abaisse de nouveau la température généralement à 780°C, comme précédemment, pour relancer la croissance de GaN ou de nitrure mixte de gallium et d'un autre métal jusqu'à l'épaisseur finale désirée (étape 6) qui est généralement de 2 à 5 *µ*m.

Il est à noter que les différents paramètres, tels que température, durée, réactifs utilisés, etc.,... des étapes de dépôt et de croissance des couches tampon, de GaN ou de nitrure mixte de gallium et d'un autre métal, ainsi que, par exemple, du traitement de surface du substrat sont connus et/ou peuvent être facilement déterminés par l'homme du métier. Les valeurs données plus haut le sont donc à titre indicatif.

Par contre, les conditions de dépôt de la couche intercalaire, monocristalline essentielle dans l'invention sont spécifiques pour précisément assurer la croissance d'une couche monocristalline.

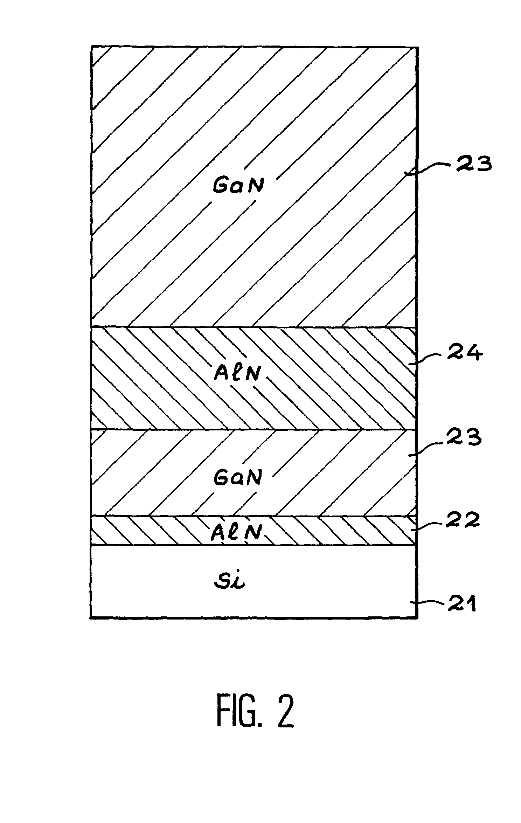

La figure 1, déjà mentionnée, schématise les différentes étapes du procédé selon l'invention, etaprès désoxydation du substrat, tandis que la figure 2 présente une coupe schématique de la structure de la couche selon l'invention, ainsi réalisée : avec un substrat (21), par exemple, en Si (111), une couche tampon, par exemple, en AlN (22) et une couche de GaN (23), dans laquelle se trouve intercalée une couche d'AlN (24).

L'invention va maintenant être décrite, en référence aux exemples suivants donnés à titre illustratif et non limitatif.

### Exemple 1

Dans cet exemple, on prépare, par épitaxie par jets moléculaires (EJM) sur un substrat en silicium, une couche de GaN de 2 *µ*m d'épaisseur, conforme à l'invention, c'est-à-dire avec une couche monocristalline intercalaire d'AlN d'épaisseur 250 *µ*m.

On chauffe sous ultra-vide le substrat de silicium pendant une dizaine d'heures autour de 600°C pour le dégazer. Puis, on l'introduit dans la chambre de croissance et on le porte rapidement à une température de l'ordre de 950°C, afin d'enlever la couche d'oxyde de silicium qui se trouve en surface. Puis, on abaisse la température à environ 600°C pour exposer la surface de silicium pendant 2 secondes au flux d'ammoniac.

Ensuite, on porte la température à 820°C et on l'abaisse de nouveau autour de 600°C. A cette température, on dépose une monocouche d'aluminium (équivalent à un dépôt de 10 secondes), puis on augmente la température à 650°C. A cette température, on envoie simultanément l'ammoniac et l'aluminium pour faire la couche tampon de nitrure d'aluminium (AlN). Pendant les deux premières minutes, on augmente progressivement la température pour atteindre une température de l'ordre de 900°C et on garde cette température pour faire croître les 50 nanomètres d'AlN de la couche tampon (soit environ 20 minutes dans nos conditions de croissance). Une fois la couche tampon terminée, on abaisse la température autour de 780°C et on lance la croissance de nitrure de gallium (GaN). On fait croître une couche de GaN de 250 nanomètres (soit environ 15 minutes dans nos conditions de croissance).

Une fois ces 250 nm réalisés, on lance la croissance de la couche monocristalline d'AlN intercalaire. Le début de la croissance se fait à 780°C, mais on augmente rapidement la température à 900°C (la montée en température dure 2 minutes). L'épaisseur de la couche d'AlN intercalaire fait 250 nm (soit environ 2 heures dans nos conditions de croissance). Une fois cette couche terminée, on abaisse la température autour de 780°C et on lance la croissance de la couche de GaN d'épaisseur 2 micromètres soit environ 2 heures.

### Exemple 2 (comparatif)

Dans cet exemple, on prépare, par Epitaxie par Jets Moléculaires (EJM) à des fins de comparaison, une couche de GaN de même épaisseur que celle de l'exemple 1 (2 *µ*m), dans les mêmes conditions que celles de l'exemple 1, mais en omettant la couche intercalaire d'AlN.

On chauffe sous ultra-vide le substrat de silicium pendant une dizaine d'heures autour de 600°C pour le dégazer. Puis, on l'introduit dans la chambre de croissance et on le porte rapidement à une température de l'ordre de 950°C, afin d'enlever la couche d'oxyde de silicium, qui se trouve en surface. Puis, on abaisse la température à environ 600°C pour exposer la surface de silicium pendant 2 secondes au flux d'ammoniac.

Ensuite, on porte la température à 820°C et on l'abaisse de nouveau autour de 600°C. A cette température, on dépose une monocouche d'aluminium (équivalent à un dépôt de 10 secondes), puis on augmente la température à 650°C. A cette température, on envoie simultanément l'ammoniac et l'aluminium pour faire la couche tampon de nitrure d'aluminium (AlN). Pendant les deux premières minutes, on augmente progressivement la température pour atteindre une température de l'ordre de 900°C et on garde cette température pour faire croître les 50 nanomètres d'AlN de la couche tampon (soit environ 20 minutes dans nos conditions de croissance). Une fois la couche tampon terminée, on abaisse la température autour de 780°C et on lance la croissance de la couche de GaN d'épaisseur 2 micromètres, soit environ 2 heures.

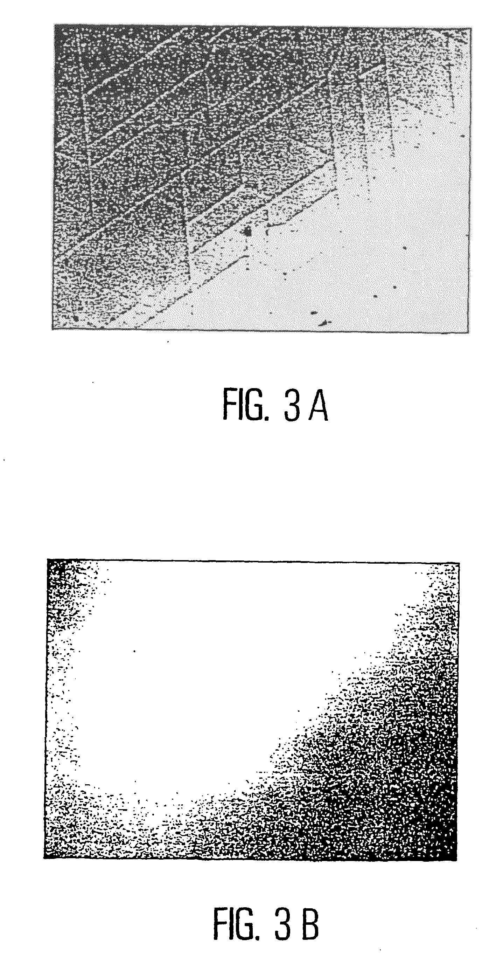

L'observation des couches préparées dans les exemples 1 et 2 au microscope optique (clichés des figures 3A et 3B) à un grossissement de x 100 montre que la couche de GaN réalisée sans la couche d'AlN intercalaire (exemple 2, figure 3A, comparative, non conforme à l'invention) est complètement craquée alors que la couche de GaN réalisée avec la couche monocristalline intercalaire (exemple 1, figure 3B, conforme à l'invention) est, continue, totalement exempte de craquelures.

### Exemple 3

Dans cet exemple, on prépare par épitaxie par jets moléculaires, dans les mêmes conditions que celles de l'exemple 1, une couche de GaN de un micromètre d'épaisseur, conforme à l'invention, c'est-à-dire avec une couche monocristalline intercalaire d'AlN de 250 nm d'épaisseur.

On chauffe sous ultra-vide le substrat de silicium pendant une dizaine d'heures autour de 600°C pour le dégazer. Puis, on l'introduit dans la chambre de croissance et on le porte rapidement à une température de l'ordre de 950°C, afin d'enlever la couche d'oxyde de silicium, qui se trouve en surface. Puis, on abaisse la température à environ 600°C pour exposer la surface de silicium pendant 2 secondes au flux d'ammoniac.

Ensuite, on porte la température à 820°C et on l'abaisse de nouveau autour de 600°C. A cette température, on dépose une monocouche d'aluminium (équivalent à un dépôt de 10 secondes), puis on augmente la température à 650°C. A cette température, on envoie simultanément l'ammoniac et l'aluminium pour faire la couche tampon de nitrure d'aluminium (AlN). Pendant les deux premières minutes, on augmente progressivement la température pour atteindre une température de l'ordre de 900°C et on garde cette température pour faire croître les 50 nanomètres d'AlN de la couche tampon (soit environ 20 minutes dans nos conditions de croissance). Une fois la couche tampon terminée, on abaisse la température autour de 780°C et on lance la croissance de nitrure de gallium (GaN). On fait croître une couche de GaN de 250 nanomètres (soit environ 15 minutes dans nos conditions de croissance).

Une fois ces 250 nm réalisés, on lance la croissance de la couche monocristalline d'AlN intercalaire. Le début de la croissance se fait à 780°C, mais on augmente rapidement la température à 900°C (la montée en température dure 2 minutes). L'épaisseur de la couche monocristalline d'AlN intercalaire fait 250 nm (soit équivalent à environ 2 heures dans nos conditions de croissance). Une fois cette couche terminée, on abaisse la température autour de 780°C et on lance la croissance de la couche de GaN d'épaisseur 1 *µ*m soit équivalent à environ 1 heure.

### Exemple 4 (comparatif)

On prépare, à des fins de comparaison, une couche de GaN de même épaisseur que celle de l'exemple 3 (1 *µ*m) dans les mêmes conditions que l'exemple 3, mais en omettant la couche monocristalline intercalaire d'AlN.

On chauffe sous ultra-vide le substrat de silicium pendant une dizaine d'heures autour de 600°C pour le dégazer. Puis, on l'introduit dans la chambre de croissance et on le porte rapidement à une température de l'ordre de 950°C, afin d'enlever la couche d'oxyde de silicium, qui se trouve en surface. Puis, on abaisse la température à environ 600°C pour exposer la surface de silicium pendant 2 secondes au flux d'ammoniac.

Ensuite, on porte la température à 820°C et on l'abaisse de nouveau autour de 600°C. A cette température, on dépose une monocouche d'aluminium (équivalent à un dépôt de 10 secondes), puis on augmente la température à 650°C. A cette température, on envoie simultanément l'ammoniac et l'aluminium pour faire la couche tampon de nitrure d'aluminium (AlN). Pendant les deux premières minutes, on augmente progressivement la température pour atteindre une température de l'ordre de 900°C et on garde cette température pour faire croître les 50 nanomètres d'AlN de la couche tampon (soit environ 20 minutes dans nos conditions de croissance). Une fois la couche tampon terminée, on abaisse la température autour de 780°C et on lance la croissance de la couche de GaN d'épaisseur 1 micromètre soit équivalent à environ 1 heure.

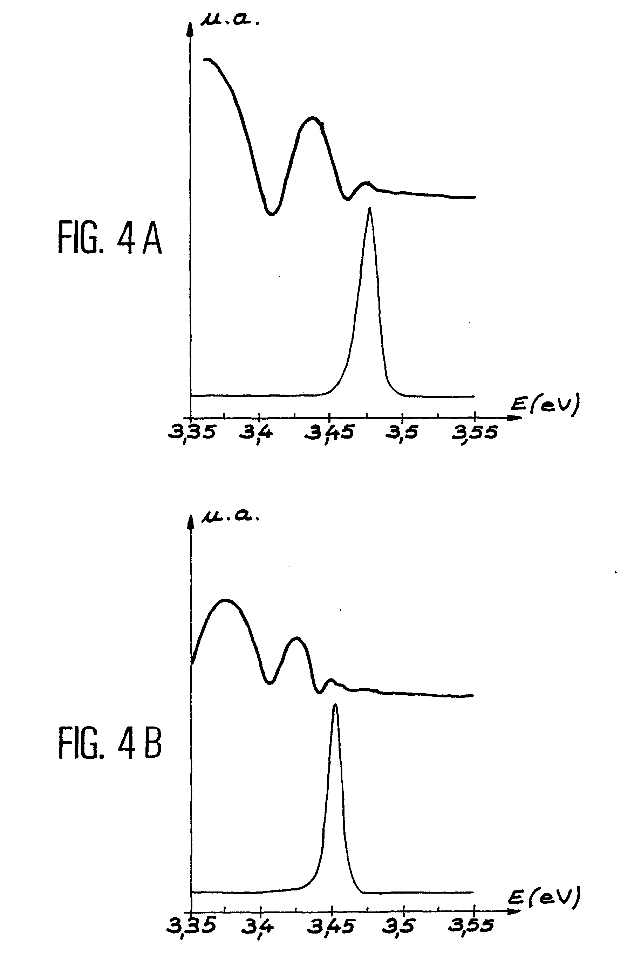

Afin de quantifier la contrainte présente dans les couches de GaN, on a combiné des expériences de photoluminescente et de réflectivité réalisées sur les couches des exemples 3 et 4. Ces expériences sont classiquement utilisées en physique des semi-conducteurs pour déterminer avec précision l'état de contrainte des matériaux. Les spectres obtenus sur les deux couches de GaN d'égale épaisseur (1 *µ*m), l'une réalisée sans la couche intercalaire (exemple 4) et l'autre réalisée avec la couche intercalaire d'AlN (exemple 3), sont présentés sur les figures 4B et 4A. L'analyse de ces spectres (il s'agit de déterminer précisément la bande interdite du matériau GaN par la position en énergie de l'exciton libre A) montre que la couche de GaN obtenue sans la couche intercalaire d'AlN est en extension alors que la couche de GaN obtenue avec la couche monocristalline intercalaire d'AlN est relaxée.

## Revendications

1. Couche (23) monocristalline, sans craquelure, de nitrure de gallium ou de nitrure mixte de gallium et d'un autre métal, sur une couche tampon (22) recouvrant un substrat (21) susceptible d'occasionner des contraintes extensives dans ladite couche (23) ladite couche (23) monocristalline, sans craquelure, étant **caractérisée en ce qu'** au moins une couche dite intercalaire (24), monocristalline, d'épaisseur comprise entre 100 et 300 nm, d'un matériau dont le paramètre de maille est inférieur au paramètre de maille du matériau de la couche (23) monocristalline, sans craquelure, est intercalée dans ladite couche (23) monocristalline, sans craquelure.

2. Couche selon la revendication 1, **caractérisée en ce que** l'épaisseur de la couche intercalaire (24) est comprise entre 200 et 250 nm.

3. Couche selon l'une des revendications 1 ou 2, **caractérisée en ce qu'**elle présente une épaisseur supérieure ou égale à 2 µm.

4. Couche selon l'une des revendications 1 à 3, **caractérisée en ce que** son épaisseur est comprise entre 2 et 5 µm.

5. Couche selon l'une des revendications 1 à 4, **caractérisée en ce que** le nitrure mixte de gallium et d'un autre métal est choisi parmi les nitrures mixtes de gallium et d'aluminium ou de gallium et d'indium.

6. Couche selon l'une des revendications 1 à 5, **caractérisée en ce que** le substrat (21) est en silicium ou en carbure de silicium.

7. Couche selon l'une des revendications 1 à 6, **caractérisée en ce que** la couche tampon (22) est en AlN.

8. Couche selon l'une des revendications 1 à 7, **caractérisée en ce que** la couche intercalaire (24) est en AlN ou en AlGaN.

9. Couche selon l'une quelconque des revendications 1 à 8, **caractérisée en ce qu'**elle comprend de 1 à 5 couches intercalaires (24).

10. Procédé pour la préparation d'une couche (23) monocristalline, sans craquelure, de nitrure de gallium ou de nitrure mixte de gallium et d'un autre métal, sur un substrat (21) susceptible d'occasionner des contraintes extensives dans la couche (23), ledit procédé étant **caractérisé en ce qu'**il comprend les étapes successives suivantes :
a) dépôt, sur le substrat (21), d'une monocouche atomique d'aluminium;
b) dépôt, sur la monocouche d'aluminium, d'une couche tampon (22) ;
c) croissance, sur la couche formée à l'étape précédente, du nitrure de gallium ou du nitrure mixte de gallium et d'un autre métal;
d) interruption de la croissance du nitrure de gallium ou du nitrure mixte de gallium et d'un autre métal;
e) croissance, sur le nitrure de gallium ou le nitrure de gallium et d'un autre métal, d'une couche monocristalline intercalaire (24) d'un matériau dont le paramètre de maille est inférieur au paramètre de maille du nitrure de gallium ou du nitrure mixte de gallium et d'un autre métal, et dont l'épaisseur est de 100 à 300 nm ;
f) poursuite de la croissance, sur la couche monocristalline intercalaire (24), du nitrure de gallium ou du nitrure mixte de gallium et d'un autre métal jusqu'à l'épaisseur finale souhaitée de la couche (23) de nitrure de gallium ou de nitrure mixte de gallium et d'un autre métal;
g) refroidissement du substrat (21) et de la couche (23) de nitrure de gallium ou de nitrure mixte de gallium et d'un autre métal.

11. Procédé selon la revendication 10, **caractérisé en ce que** le substrat (21) est en silicium et **en ce qu'**avant l'étape a) on expose la surface du substrat chauffé à de l'ammoniac.

12. Procédé selon l'une des revendications 10 ou 11, **caractérisé en ce que** l'épaisseur de la couche monocristalline intercalaire (24) est comprise entre 200 et 250 nm.

13. Procédé selon l'une des revendications 10 à 12, **caractérisé en ce qu'**entre les étapes e) et f), on répète au moins une fois les étapes c) à e), de manière à former au moins deux couches monocristallines intercalaires dans la couche (23) monocristalline, sans craquelure.

14. Procédé selon l'une des revendications 10 à 13, **caractérisé en ce que** la température de croissance de la couche intercalaire monocristalline (24) est comprise entre 800 et 1000 °C.

15. Procédé selon la revendication 14, **caractérisé en ce que** la température de croissance de la couche intercalaire monocristalline (24) est comprise entre 900 et 950°C.

16. Procédé selon l'une des revendications 10 à 15, **caractérisé en ce que** l'épaisseur finale de la couche monocristalline (23) de nitrure de gallium ou de nitrure mixte de gallium et d'un autre métal est supérieure ou égale à 2 µm.

17. Procédé selon la revendication 16, **caractérisé en ce que** l'épaisseur finale de la couche monocristalline (23) de nitrure de gallium ou de nitrure mixte de gallium et d'un autre métal est comprise entre 2 et 5 µm.

18. Procédé selon l'une des revendications 10 à 17, **caractérisé en ce que** le nitrure mixte de gallium est choisi parmi les nitrures mixtes de gallium et d'aluminium ou de gallium et d'indium.

19. Procédé selon l'une des revendications 10 à 18, **caractérisé en ce que** le substrat (21) est en silicium ou en carbure de silicium.

20. Procédé selon l'une des revendications 10 à 19, **caractérisé en ce que** la couche tampon (22) est en AIN.

21. Procédé selon l'une des revendications 10 à 20, **caractérisé en ce que** la couche monocristalline intercalaire (24) est en AlN ou en AlGaN.

22. Procédé selon la revendication 13, **caractérisé en ce que** les étapes c) à e) sont répétées de 1 à 5 fois.

23. Procédé selon l'une quelconque des revendications 10 à 22, **caractérisé en ce que** le dépôt de la couche tampon (22), la croissance du nitrure de gallium ou du nitrure mixte de gallium et d'un autre métal, et la croissance de la couche monocristalline intercalaire (24) sont réalisés par Epitaxie par Jets Moléculaires (MBE), Dépôt Chimique en Phase Vapeur d'Organométalliques (MOCVD) ou Epitaxie en Phase Vapeur par la Méthode aux Hydrures (HVPE).

24. Procédé selon la revendication 23, **caractérisé en ce que** la croissance de la couche monocristalline intercalaire (24) est réalisée par épitaxie par jets moléculaires à une température de 800 à 1000°C, à une vitesse de croissance de 0,1 à 0,5 µm/h.

25. Dispositif électronique ou optoélectronique, **caractérisé en ce qu'**il comprend au moins une couche (23) monocristalline, sans craquelure selon l'une des revendications 1 à 9.

## Patentansprüche

1. Rissfreie, monokristalline Schicht (23) aus Galliumnitrid oder Mischnitrid aus Gallium und einem weiteren Metall auf einer Pufferschicht (22), die ein Substrat (21) überdeckt, das extensive Spannungen in der Schicht (23) hervorrufen kann, wobei die rissfreie, monokristalline Schicht (23) **dadurch gekennzeichnet ist, dass** zumindest eine sogenannte Zwischenschicht (24), die monokristallin ist, eine Dicke zwischen 100 und 300 nm hat und aus einem Material besteht, dessen Gitterkonstante geringer als die Gitterkonstante des Materials der rissfreien, monokristallinen Schicht (23) ist, in die rissfreie, monokristalline Schicht (23) eingefügt ist.

2. Schicht nach Anspruch 1, **dadurch gekennzeichnet, dass** die Dicke der Zwischenschicht (24) zwischen 200 und 250 nm beträgt.

3. Schicht nach einem der Ansprüche 1 oder 2, **dadurch gekennzeichnet, dass** sie eine Dicke größer oder gleich 2 µm aufweist.

4. Schicht nach einem der Ansprüche 1 bis 3, **dadurch gekennzeichnet, dass** deren Dicke zwischen 2 und 5 µm beträgt.

5. Schicht nach einem der Ansprüche 1 bis 4, **dadurch gekennzeichnet, dass** das Mischnitrid aus Gallium und einem weiteren Metall ausgewählt ist aus Mischnitriden aus Gallium und Aluminium oder Gallium und Indium.

6. Schicht nach einem der Ansprüche 1 bis 5, **dadurch gekennzeichnet, dass** das Substrat (21) aus Silicium oder aus Siliciumcarbid besteht.

7. Schicht nach einem der Ansprüche 1 bis 6, **dadurch gekennzeichnet, dass** die Pufferschicht (22) aus AlN besteht.

8. Schicht nach einem der Ansprüche 1 bis 7, **dadurch gekennzeichnet, dass** die Zwischenschicht (24) aus AlN oder aus AlGaN besteht.

9. Schicht nach einem der Ansprüche 1 bis 8, **dadurch gekennzeichnet, dass** sie 1 bis 5 Zwischenschichten (24) aufweist.

10. Verfahren zum Herstellen einer rissfreien, monokristallinen Schicht (23) aus Galliumnitrid oder Mischnitrid aus Gallium und einem weiteren Metall auf einem Substrat (21), das extensive Spannungen in der Schicht (23) hervorrufen kann, wobei das Verfahren **dadurch gekennzeichnet ist, dass** es die nachstehenden, aufeinanderfolgenden Schritte umfasst:
a) Aufbringen einer atomaren Monoschicht aus Aluminium auf das Substrat (21);
b) Aufbringen einer Pufferschicht (22) auf die Monoschicht aus Aluminium;
c) Wachsenlassen von Galliumnitrid oder Mischnitrid aus Gallium und einem weiteren Metall auf der im vorangehenden Schritt gebildeten Schicht;
d) Unterbrechen des Wachstums von Galliumnitrid oder Mischnitrid aus Gallium und einem weiteren Metall;
e) Wachsenlassen einer monokristallinen Zwischenschicht (24) aus einem Material, dessen Gitterkonstante geringer als die Gitterkonstante von Galliumnitrid oder Mischnitrid aus Gallium und einem weiteren Metall ist und dessen Dicke 100 bis 300 nm beträgt, auf dem Galliumnitrid oder Mischnitrid aus Gallium und einem weiteren Metall;
f) Fortsetzen des Wachstums von Galliumnitrid oder Mischnitrid aus Gallium und einem weiteren Metall auf der monokristallinen Zwischenschicht (24) bis zur gewünschten Enddicke der Schicht (23) aus Galliumnitrid oder Mischnitrid aus Gallium und einem weiteren Metall;
g) Abkühlen des Substrats (21) und der Schicht (23) aus Galliumnitrid oder Mischnitrid aus Gallium und einem weiteren Metall.

11. Verfahren nach Anspruch 10, **dadurch gekennzeichnet, dass** das Substrat (21) aus Silicium besteht und dass vor dem Schritt a) die Oberfläche des erhitzten Substrats Ammoniak ausgesetzt wird.

12. Verfahren nach einem der Ansprüche 10 oder 11, **dadurch gekennzeichnet, dass** die Dicke der monokristallinen Zwischenschicht (24) zwischen 200 und 250 nm beträgt.

13. Verfahren nach einem der Ansprüche 10 bis 12, **dadurch gekennzeichnet, dass** zwischen den Schritten e) und f) zumindest einmal die Schritte c) bis e) wiederholt werden, so dass zumindest zwei monokristalline Zwischenschichten in der rissfreien, monokristallinen Schicht (23) gebildet werden.

14. Verfahren nach einem der Ansprüche 10 bis 13, **dadurch gekennzeichnet, dass** die Wachstumstemperatur der monokristallinen Zwischenschicht (24) zwischen 800 und 1000 °C beträgt.

15. Verfahren nach Anspruch 14, **dadurch gekennzeichnet, dass** die Wachstumstemperatur der monokristallinen Zwischenschicht (24) zwischen 900 und 950 °C beträgt.

16. Verfahren nach einem der Ansprüche 10 bis 15, **dadurch gekennzeichnet, dass** die Enddicke der monokristallinen Schicht (23) aus Galliumnitrid oder Mischnitrid aus Gallium und einem weiteren Metall größer oder gleich 2 µm ist.

17. Verfahren nach Anspruch 16, **dadurch gekennzeichnet, dass** die Enddicke der monokristallinen Schicht (23) aus Galliumnitrid oder Mischnitrid aus Gallium und einem weiteren Metall zwischen 2 und 5 µm beträgt.

18. Verfahren nach einem der Ansprüche 10 bis 17, **dadurch gekennzeichnet, dass** das Mischnitrid aus Gallium ausgewählt ist aus Mischnitriden aus Gallium und Aluminium oder aus Gallium und Indium.

19. Verfahren nach einem der Ansprüche 10 bis 18, **dadurch gekennzeichnet, dass** das Substrat (21) aus Silicium oder aus Siliciumcarbid besteht.

20. Verfahren nach einem der Ansprüche 10 bis 19, **dadurch gekennzeichnet, dass** die Pufferschicht (22) aus AlN besteht.

21. Verfahren nach einem der Ansprüche 10 bis 20, **dadurch gekennzeichnet, dass** die monokristalline Zwischenschicht (24) aus AlN oder aus AlGaN besteht.

22. Verfahren nach Anspruch 13, **dadurch gekennzeichnet, dass** die Schritte c) bis e) 1 bis 5 Mal wiederholt werden.

23. Verfahren nach einem der Ansprüche 10 bis 22, **dadurch gekennzeichnet, dass** das Aufbringen der Pufferschicht (22), das Wachsenlassen von Galliumnitrid oder Mischnitrid aus Gallium und einem weiteren Metall und das Wachsenlassen der monokristallinen Zwischenschicht (24) durch Molekularstrahlepitaxie (MBE), metallorganische chemische Gasphasenabscheidung (MOCVD) oder Hydridgasphasenepitaxie (HVPE) erfolgen.

24. Verfahren nach Anspruch 23, **dadurch gekennzeichnet, dass** das Wachsenlassen der monokristallinen Zwischenschicht (24) durch Molekularstrahlepitaxie bei einer Temperatur von 800 bis 1000 °C mit einer Wachstumsgeschwindigkeit zwischen 0,1 bis 0,5 µm/h erfolgt.

25. Elektronische oder optoelektronische Vorrichtung, **dadurch gekennzeichnet, dass** sie zumindest eine rissfreie, monokristalline Schicht (23) nach einem der Ansprüche 1 bis 9 aufweist.

## Claims

1. Crack-free monocrystalline layer (23) of gallium nitride or of a mixed nitride of gallium and another metal, on a buffer layer (22) covering a substrate (21) that may cause tension stresses in said layer (23); said crack-free monocrystalline layer (23) being **characterised in that** at least one so-called intermediate monocrystalline layer (24) with a thickness of between 100 and 300 nm, of a material for which the lattice parameter is smaller than the lattice parameter of the material of the crack-free monocrystalline layer (23), is inserted in said crack-free monocrystalline layer (23).

2. Layer according to claim 1, **characterised in that** the thickness of the intermediate layer (24) is between 200 and 250 nm.

3. Layer according to any of claims 1 or 2, **characterised in that** it has a thickness greater than or equal to 2 µm.

4. Layer according to any of claims 1 to 3, **characterised in that** the thickness thereof is between 2 and 5 µm.

5. Layer according to any of claims 1 to 4, **characterised in that** the mixed nitride of gallium and another metal is chosen from among the mixed nitrides of gallium and aluminium or gallium and indium.

6. Layer according to any of claims 1 to 5, **characterised in that** the substrate (21) is made of silicon or silicon carbide.

7. Layer according to any of claims 1 to 6, **characterised in that** the buffer layer (22) is made of AlN.

8. Layer according to any of claims 1 to 7, **characterised in that** the intermediate layer (24) is made of AlN or AlGaN.

9. Layer according to any of claims 1 to 8, **characterised in that** it comprises 1 to 5 intermediate layers (24).

10. Method for preparing a crack-free monocrystalline layer (23) of gallium nitride or of a mixed nitride of gallium and another metal on a substrate (21) that may cause tension stresses in the layer (23), said method comprising the following steps in sequence:
a) deposition, on the substrate (21), of a single atomic layer of aluminium;
b) deposition, on the single layer of aluminium, of a buffer layer (22);
c) growth, on the layer formed in the previous step, of the gallium nitride or of the mixed nitride of gallium and another metal;
d) interruption of the growth of the gallium nitride or of the mixed nitride of gallium and another metal;
e) growth, on the gallium nitride or the gallium nitride and another metal, of an intermediate monocrystalline layer (24) of a material for which the lattice parameter is smaller than the lattice parameter of gallium nitride or of the mixed nitride of gallium and another metal, and the thickness of which is between 100 and 300 nm;
f) continuation of the growth, on the monocrystalline intermediate layer (24), of the gallium nitride or of the mixed nitride of gallium and another metal, until the final required thickness of the layer (23) of gallium nitride or of the mixed nitride of gallium and another metal;
g) cooling of the substrate (21) and the layer (23) of gallium nitride or of the mixed nitride of gallium and another metal.

11. Method according to claim 10, **characterised in that** the substrate (21) is made of silicon and **in that**, before step a), the heated substrate surface is exposed to ammonia.

12. Method according to any of claims 10 or 11, **characterised in that** the thickness of the intermediate monocrystalline layer (24) is between 200 and 250 nm.

13. Method according to any of claims 10 to 12, **characterised in that**, between steps e) and f), steps c) to e) are repeated at least once, so as to form at least two intermediate monocrystalline layers in the crack-free monocrystalline layer (23).

14. Method according to any of claims 10 to 13, **characterised in that** the growth temperature of the intermediate monocrystalline layer (24) is between 800 and 1000°C.

15. Method according to claim 14, **characterised in that** the growth temperature of the intermediate monocrystalline layer (24) is between 900 and 950°C.

16. Method according to any of claims 10 to 15, **characterised in that** the final thickness of the monocrystalline layer (23) of gallium nitride or of the mixed nitride of gallium and another metal is greater than or equal to 2 µm.

17. Method according to claim 16, **characterised in that** the final thickness of the monocrystalline layer (23) of gallium nitride or of the mixed nitride of gallium and another metal is between 2 and 5 µm.

18. Method according to any of claims 10 to 17, **characterised in that** the mixed gallium nitride is chosen from among the mixed nitrides of gallium and aluminium or gallium and indium.

19. Method according to any of claims 10 to 18, **characterised in that** the substrate (21) is made of silicon or silicon carbide.

20. Method according to any of claims 10 to 19, **characterised in that** the buffer layer (22) is made of AlN.

21. Method according to any of claims 10 to 20, **characterised in that** the intermediate monocrystalline layer (24) is made of AlN or AlGaN.

22. Method according to claim 13, **characterised in that** steps c) to e) are repeated between 1 and 5 times.

23. Method according to any of claims 10 to 22, **characterised in that** the deposition of the buffer layer (22), the growth or deposition of gallium nitride or of the mixed nitride of gallium and another metal, and the growth of the intermediate monocrystalline layer (24) are performed by Molecular Beam Epitaxy (MBE), or Metalorganic Chemical Vapour Deposition (MOCVD), or Hydride Vapour Phase Epitaxy (HyPE).

24. Method according to claim 23, **characterised in that** the intermediate monocrystalline layer (24) is grown by Molecular Beam Epitaxy at a temperature of 800 to 1000°C, at a growth rate of 0.1 to 0.5 µm/h.

25. Electronic or opto-electronic device, **characterised in that** it comprises at least one crack-free monocrystalline layer (23) according to any of claims 1 to 9.
